**Europäisches Patentamt**

**European Patent Office**

**Office européen des brevets**

(11) Veröffentlichungsnummer: **0 225 960 B1**

# (12) EUROPÄISCHE PATENTSCHRIFT

(45) Veröffentlichungstag der Patentschrift: **20.03.91**

(21) Anmeldenummer: **86102586.4**

(22) Anmeldetag: **27.02.86**

(51) Int. Cl.5: **H03K 5/153**, H03K 5/26,
H03K 5/19, H03K 23/00,
**H03K 3/64, H03L 7/00**

(54) CMOS-Inverterkette.

(30) Priorität: **07.12.85 EP 85115598**

(43) Veröffentlichungstag der Anmeldung:
**24.06.87 Patentblatt 87/26**

(45) Bekanntmachung des Hinweises auf die
Patenterteilung:
**20.03.91 Patentblatt 91/12**

(84) Benannte Vertragsstaaten:
**DE FR GB IT NL**

(56) Entgegenhaltungen:
**DE-A- 2 450 882
DE-A- 2 541 255
GB-A- 2 066 988**

**PATENT ABSTRACTS OF JAPAN, Band 3, Nr.
159 (E-162), 27. Dezember 1979, Seite 54 E
162 & JP - A - 54 139 457**

(73) Patentinhaber: **Deutsche ITT Industries GmbH
Hans-Bunte-Strasse 19 Postfach 840
W-7800 Freiburg i.Br.(DE)**

(72) Erfinder: **Ullrich, Manfred Fritz, Dipl.-Ing.(FH)
Fischnau 10
W-7809 Denzlingen(DE)**
Erfinder: **Uhlenhoff, Arnold, Dipl.-Ing.
Hölderlinstrasse 33
W-7830 Emmendingen(DE)**

Rank Xerox (UK) Business Services

**Beschreibung**

Die Erfindung betrifft die Verwendung einer an sich bekannten CMOS-Inverter-Kette mit signalflußmäßig abwechselnd in Serie liegenden, mit dem gesteuerten Strompfad zwischen den Polen einer Gleichspannungsquelle liegenden N- bzw. P-Invertern und den weiteren Merkmalen des Oberbegriffs des Patentanspruchs 1.

Eine derartige CMOS-Inverter-Kette ist aus GB-A 2 066 988 bekannt, wobei diese Inverter-Kette der Frequenzteilung in elektronischen Uhren dient. Die CMOS-Inverter-Kette enthält dabei in Signalflußrichtung abwechselnd in Serie liegende N- bzw. P-Inverter, die aus einem üblichen CMOS-Inverter bestehen, in dessen gesteuertem Strompfad zwischen den N- und dem PTransistor bei den N-Invertern ein N-Zwischentransistor und bei den P-Invertern ein P-Zwischentransistor eingefügt ist. Alle N- bzw. P-Zwischentransistoren liegen gemeinsam mit ihrem Gateanschluß an einem einzigen Taktsignal. Der Signalausgang der N- bzw. P-Inverter ist der Verbindungspunkt von P-Transistor und N-Zwischentransistor bzw. der Verbindungspunkt von NTransistor und P-Zwischentransistor. Die Signaleingänge der N- bzw. P-Inverter sind durch die miteinander verbundenen Gates von dessen N- und P-Transistor gebildet. Jeder P- bzw. N-Inverter ist über sein Signalein- und -ausgang an die beiden jeweiligen Nachbarinverter angeschlossen, wobei der Signalausgang des letzten Inverters auf den Signaleingang des ersten Inverters zurückgekoppelt ist.

Eine andere CMOS-Inverter-Kette mit einem einzigen N-Inverter und zu diesem signalflußmäßig in Serie liegenden einzigen P-Inverter ist in der Offenlegungsschrift DE-A 24 50 882 , insbesonders in Zusammenhang mit Fig.7 beschrieben. Dabei ist der jeweilige Signaleingang das Gate des N- bzw. P-Zwischentransistors, während die in bekannter Weise verbundenen Gates des N- und des P-Transistors beim N-Inverter mit einem Taktsignal und beim P-Inverter mit dem dazu inversen Taktsignal gespeist sind. Der Zweck dieser vorbeschriebenen zweistufigen CMOS-Inverter-Kette besteht darin sicherzustellen, daß am Ausgang des P-Inverters die beiden Soll-Binärsignalpegel auftreten. Nach den weiteren Angaben dieser Offenlegungsschrift stellen der N- und der P-Zwischentransistor lediglich den einfachsten Fall eines logischen Gatters dar, das an deren Stelle in den üblichen CMOS-Inverter eingefügt werden kann. Somit ist es bei der vorbeschriebenen Anordnung möglich, vgl. Fig.11, mehrere logische CMOS-Gatter signalflußmäßig in Serie zu legen und diese dynamisch zu betreiben.

Es ist Aufgabe der Erfindung, die speziellen Eigenschaften der bereits als Frequenzteiler bekannten CMOS-Inverter-Kette zur Impulsformung zu verwenden, beispielsweise als digitaler Impuls-dauerdiskriminator, zur Kompensation von Signal-ausfällen in Impulssignalen oder als rücksetzbarer Endstandszähler, zum Beispiel in einer Schaltung zur Synchronisierung von (CMOS)-Ringoszillatoren.

Es sei angemerkt, daß in der Offenlegungsschrift DE-A 23 27 733 , insbesondere in Zusammenhang mit Fig. 2g, ein einzelner CMOS-Inverter mit Zwischentransistor beschrieben ist, dessen Gate ein Taktsignal zugeführt ist. Dieser Inverter ist jedoch Teil der Reihenauswahlschaltung eines dynamischen Speichers mit wahlfreiem Zugriff und nicht erster Inverter einer Inverter-Kette.

Die Erfindung und ihre Vorteile werden nun anhand der Figuren der Zeichnung näher erläutert.

Fig. 1 zeigt das Prinzipschaltbild der bekannten CMOS-Inverter-Kette,

Fig. 2 zeigt verschiedene Impulsformen, die in der Anordnung nach Fig. 1 bei deren Betrieb auftreten.

Fig. 3 zeigt das Schaltbild eines Ausführungsbeispiels zur Erzeugung von r Impulsen eines Ringoszillators während der Periodendauer des Taktsignals unter Verwendung einer CMOS-Inverter-Kette nach Fig. 1,

Fig. 4 zeigt ein zu Fig. 3 gehörendes Impulsdiagramm,

Fig. 5 zeigt das Schaltbild eines Ausführungsbeispiel zur Synchronisierung eines Ringoszillators unter Verwendung einer CMOS-Inverter-Kette nach Fig. 1, und

Fig. 6 zeigt ein zu Fig. 5 gehörendes Impulsdiagramm.

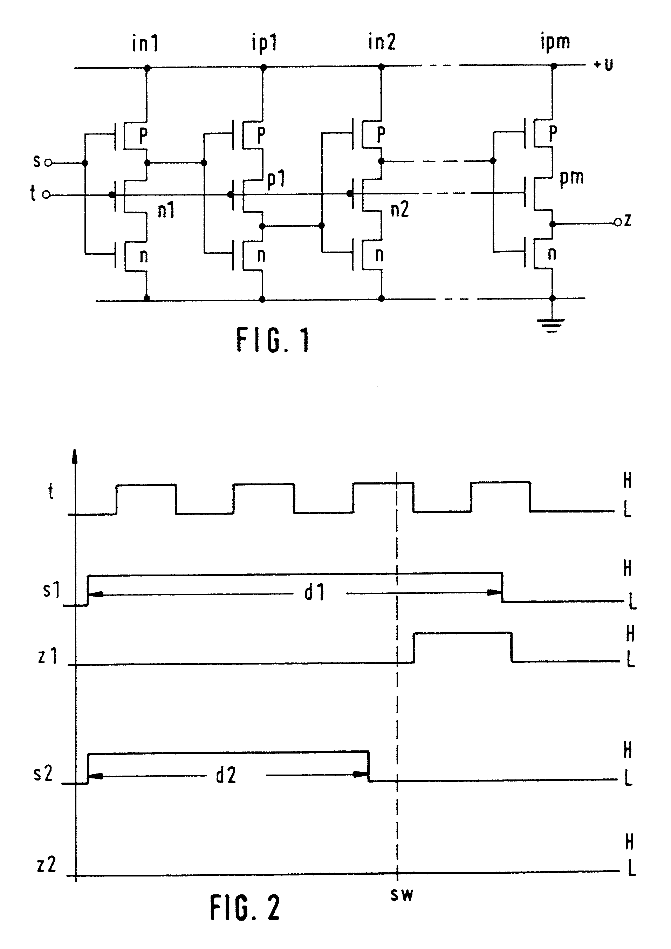

Im Schaltbild der Fig. 1 sind von einer vorausgesetzten 2m-gliedrigen Inverter-Kette vier Inverter gezeigt, nämlich die N-Inverter in1, in2 und die P-Inverter ip1, ipm. Gemeinsam sind allen Invertern der jeweilige P-Transistor, (=P-Kanal-Transistor), der mit dem einen Ende seines gesteuerten Strompfads am positiven Pcl der Gleichspannungs-quelle u liegt, und der jeweilige N-Transsistor (=N-Kanal-Transistor), der mit dem einen Ende seines gesteuerten Strompfads am Schaltungsnullpunkt liegt. In jedem Inverter ist das Gate des P-Transistors mit dem Gate des N-Transistors verbunden und stellt in bekannter Weise den Signaleingang dar, so daß an die miteinander verbundenen Gates des N-Inverters in1 das Eingangssignal s anzulegen ist.

In jedem N- bzw. P-Inverter ist zwischen dem P- und dem N-Transistor der gesteuerte Strompfad des N-Zwischentransistors n1, n2 bzw. des P-Zwischentransistors p1, pm eingefügt, so daß in jedem Inverter die gesteuerten Strompfade der drei Transistoren zwischen den Polen der Gleichspannungsquelle u in Serie liegen. Bei jedem Inverter ist der Signalausgang der jeweilige Strompfad-Verbindungspunkt von P-Transistor und N-Zwischentransistor bzw. N-Transistor und P-Zwischentransistor. Innerhalb der Inverter-Kette sind diese Ausgänge mit den miteinander verbundenen Gates von P- und N-Transistor des nachfolgenden Inverters verbunden, so daß auf einen N-Inverter ein P-Inverter und darauf wieder ein N-Inverter folgt u.s.w. Am Ausgang des letzten Inverters ipm tritt das Ausgangssignal z auf.

Die Inverter-Kette hat folgende Eigenschaften, die für die Erfindung verwendet werden:

Wird ein impulsförmiges Eingangssignal s dem Ketteneingang zugeführt, so wandert die eine Impulsflanke, gesteuert durch das Taktsignal t durch die Kette hindurch und kann nach m Taktimpulsperioden, die die Gesamtverzögerungszeit der Kette ist, als entsprechende Impulsflanke am Kettenausgang abgenommen werden. Die zu dieser Impulsflanke entgegengerichtete Flanke wandert jedoch unabhängig vom Taktsignal so schnell durch die Inverter-Kette, daß sie bereits zu einem wesentlich früheren Zeitpunkt am Kettenausgang erscheint, der der 2m-fachen, rein inverter-aufbau-bedingten Verzögerungszeit entspricht, die im folgenden als Eigenverzögerungszeit der Inverter-Kette bezeichnet ist. Ist die erwähnte erste Flanke zu diesem Zeitpunkt noch nicht am Inverterausgang angekommen, so wird sie von der erwähnten zweiten Flanke sozusagen überholt und dabei gelöscht.

Auf den ersten Blick erscheint diese Eigenschaft der Inverter-Kette als nachteilig, denn es können nur Impulse mit einer Impulsdauer, die größer als die erwähnten m Taktimpulsperioden ist, die Kette durchlaufen. Diese Eigenschaft kann aber nach der Erfindung dazu benutzt werden, die Impulsdauer von Impulsen digital festzustellen, d.h. bei Impulsdauern unterhalb einer vorgegebenen Impulsdauer-Schwelle den einen zweier Binärsignalpegel H, L und bei Impulsdauern, die größer als diese Schwelle sind, den anderen Binärsignalpegel zu erzeugen. Die Impulsdauer-Schwelle ist die Differenz aus der erwähnten Gesamt- und der Eigenverzögerungszeit.

Zur Veranschaulichung dieses Sachverhalts dienen die Impulsverläufe der Fig. 2. Es sind einige Impulse des Taktsignals t gezeigt, ferner ein erstes Eingangssignal s1, dessen Dauer d1 größer als die Impulsdauer-Schwelle sw ist. Demzufolge ergibt sich ein erstes Ausgangssignal z1. Die Impulsdauer d2 des zweiten Eingangssignals s2 ist jedoch kürzer als die Impulsdauer-Schwelle sw, so daß als zweites. Ausgangssignal z2 lediglich ein dauernder L-Pegel auftritt.

Die oben erwähnte Eigenschaft der CMOS-Inverter-Kette kann nach der Erfindung auch ferner benutzt werden, Signalausfälle von Eingangsimpulsen zu kompensieren, deren Impulsdauer größer als die erwähnte Differenz, also größer als der erwähnte Impulsdauer-Schwellwert sw ist, wenn die Signalausfallzeit kleiner als dieser Schwellwert ist. In diesem Fall läuft die eine Flanke ungetaktet mit maximaler Geschwindigkeit durch die Kette; die durch einen kurzen Signalausfall unerwünscht hervorgerufene, gegenläufige Flanke läuft getaktet durch die Kette, erreicht aber ihr Ende nicht, weil sie vor Erreichen des Endes schon von der anderen Flanke gelöscht wird.

Beginnt, wie in Fig. 1 gezeigt ist, die CMOS-Inverter-Kette mit einem N-Inverter, so wird die L/H-Flanke eines Impulses taktgesteuert innerhalb der Kette verschoben. Beginnt die Kette mit einem P-Inverter, so ist es die H/L-Flanke, die der Taktsteuerung unterliegt.

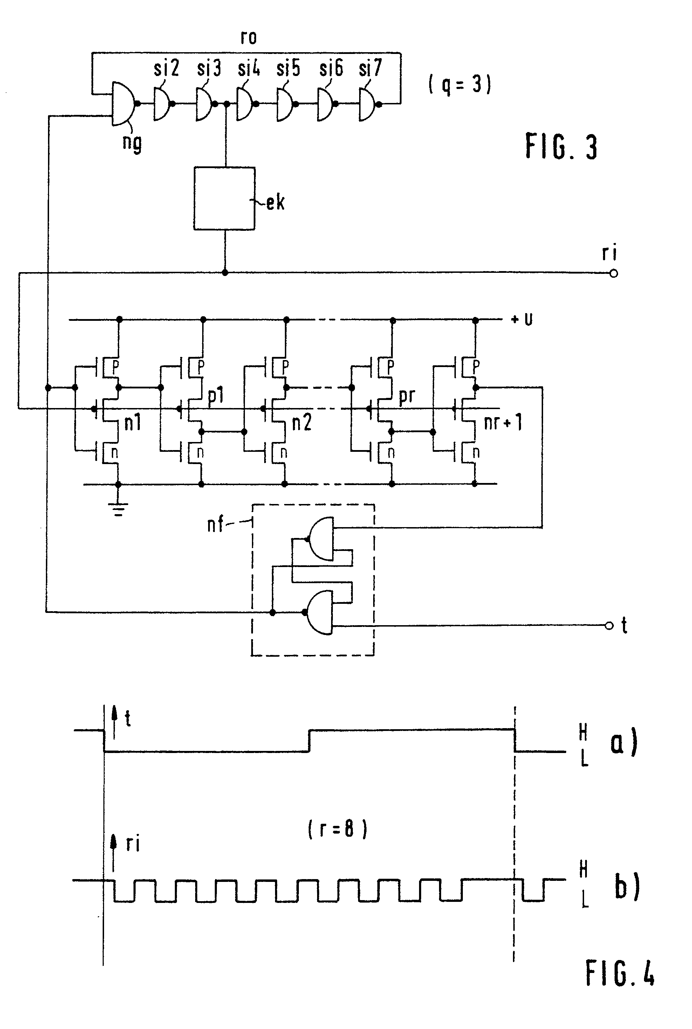

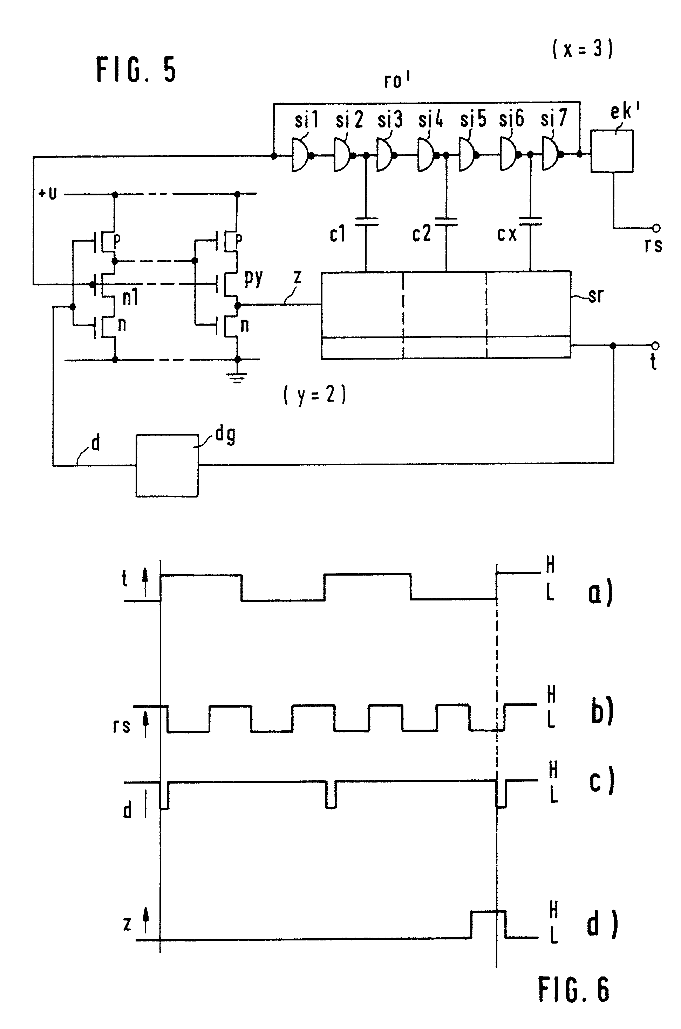

Die Fig. 3 zeigt das Schaltbild eines Ausführungsbeispiels zur Erzeugung von r Impulsen ri des Ringoszillators ro während der Periodendauer des Taktsignals t unter Verwendung einer CMOS-Inverterkette nach Fig. 1. Die Inverterkette ist dabei wie auch bei Fig. 5 als rücksetzbarer Endstandzähler verwendet, der bei Erreichen eines durch die "Lange" (Stufenzahl) der Inverterkette vorgegebenen Zählerstandes einen Ausgangsimpuls abgibt.

In dieser Verwendungsschaltung besteht die Inverterkette aus 2r + 1 Invertern n1, p1, n2...pr, nr + 1. Der Ringoszillator ro besteht aus einer ungeraden Anzahl 2q + 1 von signalflußmäßig in Serie geschalteten und vom Ausgang des letzten zum Eingang des ersten rückgekoppelten CMOS-Standard-Invertern, wobei in Fig. 3 der erste Standardinverter durch das NAND-Gatter ng ersetzt ist. In Fig. 3 ist der Ringoszillator ro rein beispielsweise als solcher gezeigt, der entsprechend der Laufzahl q = 3 sieben Stufen hat, nämlich das bereits erwähnte NAND-Gatter ng und die Standard-Inverter si2, si3, si4, si5, si6, si7. Dabei ist der Ausgang des letzten Standardinverters si7 mit einem der beiden Eingänge des NAND-Gatters ng verbunden.

Als CMOS-Standard-Inverter ist dabei ein üblicher Inverter aus einem N-Kanal- und einem P-Kanal-Enhancement-Isolierschicht-Feldeffekttransistor bezeichnet, deren gesteuerte Strompfade in Serie geschaltet sind und zwischen den beiden Polen der Betriebsspannungsquelle liegen sowie deren miteinander verbundene Gates der Signaleingang und deren Strompfad-Verbindungspunkt der Signalausgang ist.

Das Ausgangssignal des Ringoszillators ro ist am Ausgang des q-ten Standard-Inverters si3 über die Entkoppelstufe ek abgegriffen und dem Takteingang der Inverterkette zugeführt. Die Entkoppelstufe ek kann beispielsweise aus einigen in Reihe liegenden weiteren CMOS-Standard-Invertern bestehn, so daß die am Ausgang der Entkoppelstufe ek angeschlossenen Teilschaltungen die Schwingfrequenz des Ringoszillators ro nicht unerwünscht beeinflussen können.

Das Taktsignal t liegt am ersten Eingang des aus zwei weiteren NAND-Gattern bestehenden Flipflops nf, das im folgenden als NAND-Flipflop bezeichnet ist. Der Signalausgang des letzten Inverters nr + 1 der Inverterkette liegt am zweiten Eingang des NAND-Flipflops nf, und dessen zum ersten Eingang gehörender Ausgang ist am Signaleingang der Inverterkette angeschlossen.

Die Fig. 4 zeigt zwei Signalverläufe, die in der Anordnung nach Fig. 3 auftreten, und zwar das Taktsignal t und das Ausgangssignal ri, also di beabsichtigten r Impulse des Ringoszillators ro. Für die Fig. 4 ist angenommen, daß acht Impulse ri innerhalb der Periodendauer des Taktsignals t erzeugt werden sollen, also r = 8 gilt. Wie die am rechten Ende des Kurvenverlaufs der Fig. 4b gezeigte Impulspause veranschaulicht, ist durch Bemessung der Frequenz des Taktsignals t im Hinblick auf die Frequenz des Ringoszillators ro und die Anzahl r der zu erzeugenden Impulse zu berücksichtigen, daß die Ringoszillatorfrequenz während des Betriebs schwanken kann. Es ist also die Taktsignalfrequenz t immer größer als die r-fache Ringoszillatorfrequenz zu wählen, damit bei allen vorgesehenen Betriebsbedingungen die r Impulse sicher erzeugt werden können.

Bei der Anordnung nach Fig. 3 wird die CMOS-Inverterkette so betrieben, daß das Taktsignal t das die Inverterkette durchlaufende Signal ist, während das Signal des Ringoszillators ro als deren Taktsignal dient. Unter Berücksichtigung dieses Sachverhalts und ferner, daß das NAND-Flipflop nf ein RS-Flipflop mit einem S-Eingang (= erster Eingang), mit einem R-Eingang ( = zweiter Eingang) und mit einem Q-Ausgang ist, ergibt sich die den Impulsverläufen der Fig. 4 entsprechende Wirkungsweise ohne weiteres.

Bei der in Fig. 5 gezeigten Schaltung eines Ausführungsbeispiels einer weiteren erfindungsgemäßen Verwendung der CMOS-Inverterkette dient diese der derartigen Synchronisierung eines aus einer ungeraden Anzahl 2x + 1 von signalflußmäßig in Serie geschalteten und vom Ausgang des letzten zum Eingang des ersten Inverters zurückgekoppelten CMOS-Standard-Invertern si1...si7 bestehenden Ringoszillators ro', daß während einer Taktsignalperiode im Mittel y Ringoszillatorimpulse rs auftreten. Bei dieser bevorzugten Verwendung besteht die Inverterkette aus einer geraden Anzahl von 2y Invertern n1....py. Der Ausgang des letzten Standard-Inverters si7 des Ringoszillators ro' liegt am Takteingang der Inverterkette und über die Entkoppelstufe ek' am Signalausgang. Der Ausgang der Inverterkette liegt am Serieneinang des x-stufigen Schieberegisters sr, dessen Takteingang mit dem Taktsignal t gespeist ist. Der Signaleingang der Inverterkette ist über das Differenzierglied dg vom Taktsignal t angesteuert. Jeder Ausgang eines geradzahligen Standard-Inverters si2, si4, si6 ist über einen Kondensator c1, c2, cx mit dem jeweiligen Stufenausgang des Schieberegisters sr verbunden.

Die Fig. 6 zeigt vier verschiedene, zu der Anordnung nach Fig. 5 gehörende Kurvenverläufe. In Fig. 6a ist der Verlauf des Taktsignals t, in Fig. 6b der Verlauf der Ringoszillatorimpulse rs, in Fig. 6c der Verlauf des Ausgangssignals d des Differenzierglieds dg und in Fig. 6d der Verlauf des Ausgangssignals z der Inverterkette gezeigt, und zwar für den Fall, daß y = 2 ist.

Wie aus Fig. 6b ersichtlich ist, variiert während der Taktsignalperiode die Dauer der einzelnen Ringoszillatorimpulse, was durch Zu- und Abschalten der Kondensatoren c1...cx an den Ausgängen der geradzahligen Standard-Inverter si2, si4, si6 erreicht wird. Dadurch ergibt sich eine Regelung der Frequenz des Ringoszillators ro' in Bezug auf die Frequenz des Taktsignals t und damit eine Synchronisierung, die hier etwa als gleitende Synchronisierung während jeweils y Taktsignalperioden bezeichnet werden kann.

Es ist ohne weiteres klar, daß sich die CMOS-Inverterkette sowie die Zusatzschaltungen nach Fig. 3 und 5 zur Realisierung als monolithisch integrierte Halbleiterschaltung eignen, wie dies auf alle CMOS-Schaltungen zutrifft.

## Ansprüche

1. Verwendung einer an sich bekannten CMOS-Inverterkette mit mindestens zwei signalflußmäßig abwechselnd in Serie liegenden, mit dem gesteuerten Strompfad zwischen den Polen einer Gleichspannungsquelle (u) liegenden N- bzw. P-Invertern (in1, ip1, in2, ipm), wobei

   - jeder N-Inverter (in..) aus einem üblichen CMOS-Inverter, in dessen gesteuerten Strompfad zwischen dem N- und dem P-Transistor (n, p) ein N-Zwischentransistor (n1, n2) eingefügt ist, und

   - jeder P-Inverter (ip..) aus einem üblichen CMOS-Inverter, dessen gesteuerten Strompfad zwischen dem N- und dem P-Transistor (n, p) ein P-Zwischentransistor (p1, pm) eingefügt ist, besteht,

   - der Signalausgang des N- bzw. des P-Inverters der Verbindungspunkt von P-Transistor und N-Zwischentransistor bzw. der Verbindungspunkt von N-Transistor und P-Zwischentransistor ist,

   - die N- bzw. P-Inverter getaktet sind,

   - an den ersten (N- bzw. P-) Inverter der Kette ein Eingangssignal (s) angelegt ist,

   - die Gates der N- und der P-Zwischentransistoren (n1.. pm), denen ein einziges Taktsignal (t) zugeführt ist, miteinander verbunden sind und

- der Signaleingang jedes N- bzw. P-Inverters durch die miteinander verbundenen Gates von dessen N- und P-Transistor gebildet ist,

dadurch gekennzeichnet, daß

die CMOS-Inverter-Kette als digitaler Impulsdiskriminator dient, der für die Impulsdauer eines EingangsimpulseS, die größer als die Differenz aus der Gesamt- und der Eigenverzögerungszeit ist, einen Ausgangsimpuls abgibt.

2. Verwendung einer CMOS-Inverterkette, wobei die CMOS-Inverterkette von der im Anspruch 1 angeführten Art ist, zur Kompensation von Signalausfällen während Eingangsimpulsen, deren Impulsdauer größer als die Differenz der Gesamt- und der Eigenverzögerungszeit ist, wenn die Signalausfallzeit kleiner als diese Differenz ist.

3. Verwendung einer CMOS-Inverterkette, wobei die CMOS-Inverterkette von der im Anspruch 1 angeführten Art ist, rücksetzbarer Endstandzähler, der bei Erreichen eines durch die Länge der Inverterkette vorgegebenen Zählerstandes einen Ausgangsimpuls ergibt.

4. Verwendung einer CMOS-Inverterkette, wobei die CMOS-Inverterkette von der im Anspruch 1 angeführten Art ist, zur Erzeugung von r Impulsen (ri) eines aus einer ungeraden Anzahl (2q + 1) signalflußmäßig in Serie geschalteten und vom Ausgang des letzten zum Eingang des ersten Inverters zurückgekoppelten CMOS-Standard-Invertern (si....) bestehenden Ringoszillators (ro) während der Periodendauer des Taktsignals (t), gekennzeichnet durch folgende Merkmale:

- die Inverterkette besteht aus 2r + 1-Invertern (n1... nr + 1),
- der erste Standard-Inverter des Ringoszillators (ro) ist durch ein NAND-Gatter (ng) ersetzt, dessen erster Eingang mit dem Ausgang des letzten Standard- Inverters (si7) verbunden ist und dessen zweiter Eingang am Signaleingang der Inverterkette liegt,
- das Ausgangssignal des Ringoszillators (ro) ist über eine Entkoppelstufe (ek) abgegriffen und dem Takteingang der Inverterkette zugeführt,
- das Taktsignal (t) liegt am ersten Eingang eines aus zwei NAND-Gattern bestehenden Flipflops (nf) ,und
- der Signalausgang des letzten Inverters

(nr + 1) der Inverterkette liegt am zweiten Eingang des genannten Flipflops (nf), dessen zum ersten Eingang gehörender Ausgang am Signaleingang der Inverterkette angeschlossen ist.

5. Verwendung einer CMOS-Inverterkette, wobei die CMOS-Inverterkette von der im Anspruch 1 angeführten Art ist, zur derartigen Synchronisierung eines aus einer ungeraden Anzahl (2x + 1) von signalflußmäßig in Serie geschalteten und vom Ausgang des letzten zum Eingang des ersten zurückgekoppelten CMOS-Standard-Invertern (si...) bestehenden Ringoszillators (ro') mit dem Taktsignal (t), daß während einer Taktsignalperiode im Mittel y Ringoszillatorimpulse (rs) auftreten, gekennzeichnet durch folgende Merkmale:

- die Inverterkette besteht aus einer geraden Anzahl von 2y Invertern (n1...py),
- der Ausgang des letzten Standard-Inverters (si) liegt am Takteingang der Inverterkette und über eine Entkoppelstufe (ek') am Signalausgang,
- der Ausgang der Inverterkette liegt am Serieneingang eines x-stufigen Schieberegisters (sr), dessen Takteingang mit dem Taktsignal (t) gespeist ist,
- der Signaleingang der Inverterkette ist über ein Differenzierglied (dg) vom Taktsignal (t) angesteuert, und
- jeder Ausgang eines geradzahligen Standard- Inverters (si2, si4, si6) ist über einen Kondensator (c1, c2, cx) mit dem jeweiligen Stufenausgang des Schieberegisters (sr) verbunden.

## Claims

1. Use of a conventional CMOS inverter chain comprising at least two N and P inverters (in1, ip1, in2, ipm) alternately connected in cascade and having their controlled current paths connected between the terminals of a DC voltage source (u) wherein

- each N inverter (in..) consists of a conventional CMOS inverter having an N intermediate transistor (n1, n2) inserted in its controlled current paths between the N transistor (n) and the P transistor (p),
- each P inverter (ip..) consists of a conventional CMOS inverter having a P intermediate transistor (p1, pm) inserted in its controlled current path between the N transistor (n) and the P transistor (p),
- the signal output of the N inverter is the node of the P transistor and the N intermediate transistor, and the signal output of the P inverter is the node of the N transistor and the P intermediate transistor,

- the N and P inverters are clocked,
- an input signal (s) is applied to the first (N or P) inverter of the inverter chain,
- the gates of the N and P intermediate transistors (n1.. pm), to which a single clock signal (t) is applied, are interconnected, and
- the signal input of each of the N and P inverters is formed by the interconnected gates of the N and P transistors of the inverter.

characterized in that

the CMOS inverter chain serves as a digital pulse discriminator which delivers an output pulse if the duration of an input pulse is greater than the difference between the total delay and the inherent delay of the inverter chain.

2. Use of a CMOS inverter chain of the type set forth in claim 1 to compensate for dropouts during input signals whose pulse duration is greater than the difference between the total delay and the inherent delay of the chain if the dropout is shorter than said difference.

3. Use of a CMOS inverter chain of the type set forth in claim 1 as a resettable preset counter which delivers an out put pulse when the count reaches a number predetermined by the length of the inverter chain.

4. Use of a CMOS inverter chain of the type set forth in claim 1 for generating r pulses (ri) of a ring oscil-lator (ro) consisting of an odd number (2q + 1) of cascaded CMOS standard inverters (si...), with the output of the last CMOS standard inverter fed back to the input of the first, during the period of the clock signal (t), characterized by the following features:

- The inverter chain consists of 2r + 1 inverters (n1... nr + 1);
- the first standard inverter of the ring oscillator (ro) is replaced by a NAND gate (ng) whose first input is connected to the output of the last standard inverter (si7), and whose second input is coupled to the signal input of the inverter chain;
- the output signal from the ring oscillator (ro) is passed through a decoupling stage (ek) and applied to the clock input of the inverter chain;
- the clock signal (t) is applied to the first input of a flip-flop (nf) consisting of two NAND gates, and

- the signal output of the last inverter (nr + 1) of the inverter chain is coupled to the second input of said flip-flop (nf), whose output, which is associated with the first input, is connected to the signal input of the inverter chain.

5. Use of a CMOS inverter chain of the type set forth in claim 1 for synchronizing a ring oscillator (ro') with the clock signal (t), said ring oscillator (ro') consisting of an odd number (2x + 1) of cascaded CMOS standard inver-ters (si...), with the output of the last CMOS standard inverter fed back to the input of the first, such that, on the average, y ring-oscillator pulses (rs) occur during one clock period, characterized by the following features:

- The inverter chain consists of an even number of 2y inverters (n1...py);
- the output of the last standard inverter (si) is coupled to the clock input of the inverter chain and through a decoupling stage (ek') to the signal output;
- the output of the inverter chain is coupled to the serial input of an x-stage shift register (sr) whose clock input is fed with the clock signal (t);
- the signal input of the inverter chain is driven by the clock signal (t) via a differentiator (dg), and
- the output of each even-numbered standard inverter (si2, si4, si6) is connected through a capacitor (c1, c2, cx) to the associated stage output of the shift register (sr).

**Revendications**

1. Utilisation d'une chaîne d'inverseurs CMOS connue en soi, comportant au moins deux inverseurs de type N et P (in1,ip1,in2,ipm), branchés alternativement en série, dans le sens du flux de transmission des signaux et dont la voie de courant commandée est branchée entre les pôles d'une source de tension continue (u), et dans laquelle

- chaque inverseur de type N (in...) est constitué par un inverseur CMOS usuel, dans la voie de courant commandée duquel est inséré, entre les transistors de type N et de type P (n,p), un transistor intercalaire de type N (n1,n2), et
- chaque inverseur de type P (ip...) est constitué par un inverseur CMOS usuel, dans la voie de courant commandée duquel est inséré, entre les transistors de type N et P (n,p), un transistor intercalaire de type P (p1,pm),

- les sorties des signaux des inverseurs de type N et P sont le point de jonction du transistor de type P et du transistor intercalaire de type N et le point de jonction du transistor de type N et du transistor intercalaire de type P,
- les inverseurs de type N et P sont commandés de façon cadencée,
- un signal d'entrée (s) est appliqué aux premiers inverseurs (de type N et de type P) de la chaîne,
- les grilles des transistors intercalaires de type N et de type P (n1...pm), auxquelles un seul signal de cadence (t) est envoyé, sont reliées entre elles, et
- l'entrée des signaux de chaque inverseur de type N ou de type P est formée par les grilles, reliées entre elles, du transistor de type M et du transistor de type P de cet inverseur,

caractérisé par le fait que

la chaîne des inverseurs CMOS est utilisée en tant que discriminateur numérique d'impulsions, qui délivre une impulsion de sortie pendant la durée d'une impulsion d'entrée supérieure à la différence entre le retard total et le retard propre.

2. Utilisation d'une chaîne d'inverseurs CMOS du type indiquée dans la revendication 1, pour la compensation de manques de signaux pendant des impulsions d'entrée, dont la durée est supérieure à la différence entre le retard total et le retard propre, lorsque le temps d'interruption des signaux est inférieur à cette différence.

3. Utilisation d'une chaîne d'inverseurs CMOS du type indiqué dans la revendication 1, en tant que compteur d'état final pouvant être ramené à zéro, qui, lorsqu'il atteint un état de comptage prédéterminé par la longueur de la chaîne des inverseurs, délivre une impulsion de sortie.

4. Utilisation d'une chaîne d'inverseurs CMOS du type indiqué dans la revendication 1, pour produire r impulsions (ri) d'un oscillateur en anneau (ro), constitué par un nombre impair (2q + 1) d'inverseurs standards CMOS (si...) branchés en série dans le sens du flux de transmission des signaux et dont la sortie du dernier est couplée par réaction à l'entrée du premier, pendant la durée de la période du signal de cadence (t), caractérisé par les caractéristiques suivantes :

- la chaîne d'inverseurs est constituée par 2r + 1 inverseurs (n1...nr + 1),
- le premier inverseur standard de l'oscillateur en anneau (ro) est remplacé par une porte NON-ET (ng), dont la première entrée est reliée à la sortie du dernier inverseur standard (si7) et dont la seconde entrée est raccordée à l'entrée des signaux de la chaîne d'inverseurs,
- le signal de sortie de l'oscillateur en anneau (ro) est prélevé au moyen d'un étage de découplage (ek) et est envoyé à l'entrée de cadence de la chaîne d'inverseurs,
- le signal de cadence (e) est appliqué à la première entrée d'une bascule bistable (nf) constituée par deux portes NON-ET, et
- la sortie des signaux du dernier inverseur (nr + 1) de la chaîne d'inverseurs est raccordée à la seconde entrée de ladite bascule bistable (nf), dont la sortie associée à la première entrée est raccordée à l'entrée des signaux de la chaîne d'inverseurs.

5. Utilisation d'une chaîne d'inverseurs CMOS du type indiqué dans la revendication 1 pour réaliser, au moyen du signal de cadence (t), une synchronisation telle d'un oscillateur en anneau (ro'), constitué par un nombre impair (2x + 1) d' inverseurs standards CMOS (si...) branchés en série dans le sens du flux de transmission de signaux et dont la sortie du dernier est couplée par réaction à l'entrée du premier, que pendant une période du signal de cadence, il apparaît en moyenne y impulsions (rs) de l'oscillateur en anneau, caractérisé par les caractéristiques suivantes :

- la chaîne d'inverseurs est constituée par un nombre pair 2y d'inverseurs (n1...py),
- la sortie du dernier inverseur standard (si) est raccordée à l'entrée de cadence de la chaîne d'inverseurs et, par l'intermédiaire d'un étage de découplage (ek'), à la sortie des signaux,
- la sortie de la chaîne d'inverseurs est raccordée à l'entrée série d'un registre à décalage (sr) comportant x étages et dont l'entrée de cadence est alimentée par le signal de cadence (t),
- l'entrée des signaux dans la chaîne d'inverseurs est commandée par l'intermédiaire d'un circuit différentiateur (dg), par le signal de cadence (t),
- chaque sortie d'un inverseur standard pair (si2,si4,si6) est raccordée par un condensateur (c1,c2,cx), à la sortie respective d'un étage du registre à décalage (sr).

EP 0 225 960 B1

FIG. 1

FIG. 2

9

FIG. 3

( q = 3 )

( r = 8 )

FIG. 4

**FIG. 5**

$( x = 3 )$

$( y = 2 )$

**FIG. 6**